(19) Europäisches Patentamt
European Patent Office
Office européen des brevets

(11) **EP 4 488 754 A1**

(12) **EUROPEAN PATENT APPLICATION**

(43) Date of publication:
**08.01.2025 Bulletin 2025/02**

(21) Application number: **23183484.7**

(22) Date of filing: **05.07.2023**

(51) International Patent Classification (IPC):
*G03F 7/00* $^{(2006.01)}$    *G01N 21/956* $^{(2006.01)}$
*G02F 1/37* $^{(2006.01)}$    *H05G 2/00* $^{(2006.01)}$

(52) Cooperative Patent Classification (CPC):
**G03F 7/706847; G01N 21/956; G02F 1/37**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
• **NIENHUYS, Han-Kwang**
**5500 AH Veldhoven (NL)**
• **SMORENBURG, Petrus, Wilhelmus**
**5500 AH Veldhoven (NL)**
• **TAO, Yin**
**5500 AH Veldhoven (NL)**
• **EDWARD, Stephen**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD AND APPARATUS FOR IMPROVING ACCURACY OF SOFT X-RAY METROLOGY**

(57) A method for improving accuracy of SXR metrology, comprising: obtaining a first diffraction spectrum comprising a plurality of periodic discrete peaks and relating to a target structure having been illuminated with a first source spectrum; obtaining a second diffraction spectrum relating to said target structure having been illuminated with a second source spectrum, the second source spectrum being complementary to the first source spectrum; determining a first response spectrum of the target structure based on the first source spectrum and the first diffraction spectrum; determining a second response spectrum of the target structure on the second source spectrum and the second diffraction spectrum; combining the first response spectrum with the second response spectrum to construct an improved response spectrum having fewer gaps than the first response spectrum; and determining a property of interest of the target structure using the improved response spectrum.

1000

110

120

130

140

**Fig. 10**

EP 4 488 754 A1

**Description**

FIELD

The present invention relates to a method for improving accuracy of soft X-ray (SXR) metrology and various configurations of a SXR illumination source for use with said method.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low $k_1$.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray (SXR) and/or EUV radiation) may be using a pump radiation (e.g., infrared IR radiation) to excite a generating medium, thereby generating an emitted radiation, optionally a high harmonic generation comprising high frequency radiation.

It is desirable to improve the accuracy of semiconductor metrology or inspection.

SUMMARY

According to a first aspect of the invention, there is provided a method comprising: measuring a structure with a first radiation generated with a first spectrum to obtain a first measured signal. The first radiation is generated via an interaction between a pump beam and a medium. The method further comprises varying at least one of the pump beam and the medium to generate a second radiation with a second spectrum. The second spectrum is different from the first spectrum. The method further comprises measuring the structure with the second radiation subsequently to obtain a second measured signal, and combining the first measured signal and the second measured signal to obtain a parameter of interest of the structure.

According to a second aspect of the invention, there is provided a computer program comprising program instructions operable to perform the method above, when run on a suitable apparatus.

According to a third aspect of the invention, there is provided a metrology tool for measuring and/or inferring properties of a patterned structure on a substrate, comprising a non-transient computer program carrier comprising a computer program according to the second aspect.

According to a fourth aspect of the invention, there is provided a radiation source operable to output two radiation beams with different spectra having wavelengths via an interaction between a pump beam and a medium, wherein the radiation source is configured to vary at least one of the pump beam and the medium to generate the two radiation beams with different spectra.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts a schematic representation of a SXR illumination source configured to output a SXR beam for SXR metrology;
- Figure 9(a) shows an example source spectrum; Figure 9(b) shows an example response spectrum of a target; Figure 9(c) shows an example measured spectrum that is not convolved with a point-spread function associated with the SXR radiation beam; Figure 9(d) shows an example measured spectrum that is a result of the spectrum shown in Figure 9(c) being convolved with a point-spread associated with the SXR radiation beam.
- Figure 10 shows a flow diagram of steps in a method for improving accuracy of SXR metrology;
- Figures 11(a)-11(c) show respectively a first response spectrum, a second response spectrum and a constructed response spectrum obtained by combining the first response spectrum and the second response spectrum;
- Figure 12 depicts a schematic representation of a SXR illumination source configured in a different configuration where two different SXR spectra are provided for use with the method of Figure 10;
- Figure 13 depicts a schematic representation of a SXR illumination source configured in another different configuration where two different SXR spectra are provided for use with the method of Figure 10;

- Figure 14 depicts a schematic representation of a SXR illumination source configured in another different configuration where two different SXR spectra are provided for use with the method of Figure 10;

- Figure 15 depicts a schematic representation of a SXR illumination source configured in another different configuration where two different SXR spectra are provided for use with the method of Figure 10;

- Figure 16 depicts a schematic representation of a SXR illumination source configured in another different configuration where two different SXR spectra are provided for use with the method of Figure 10; and

- Figure 17 depicts a schematic representation of a SXR illumination source configured in another different configuration where two different SXR spectra are provided for use with the method of Figure 10.

## DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

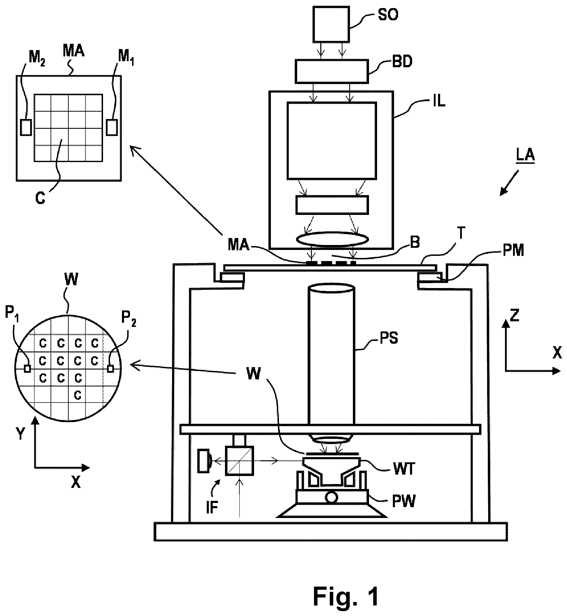

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

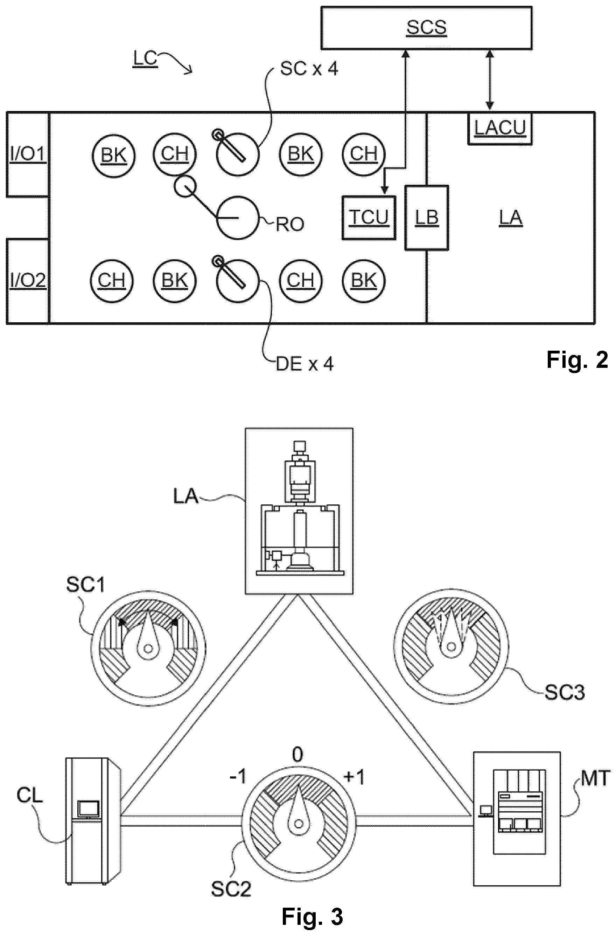

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

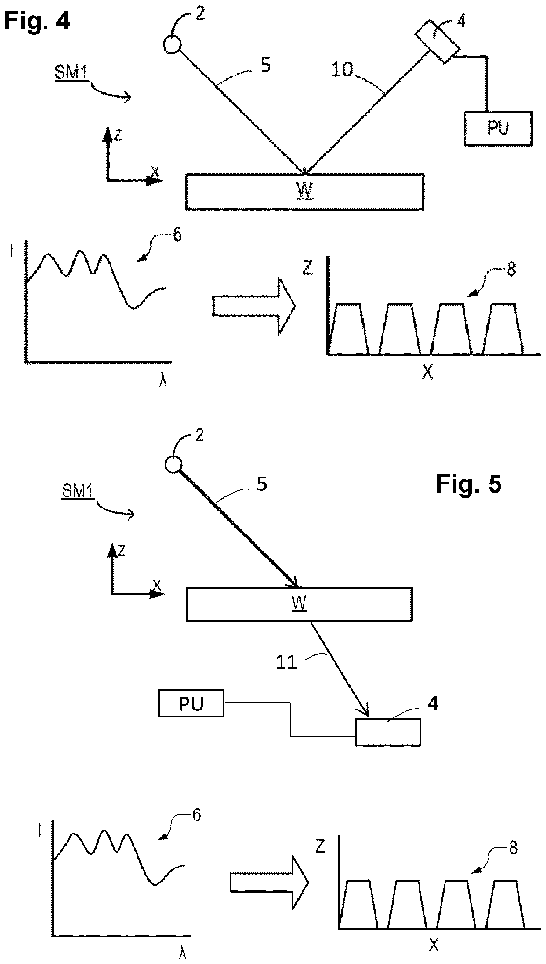

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

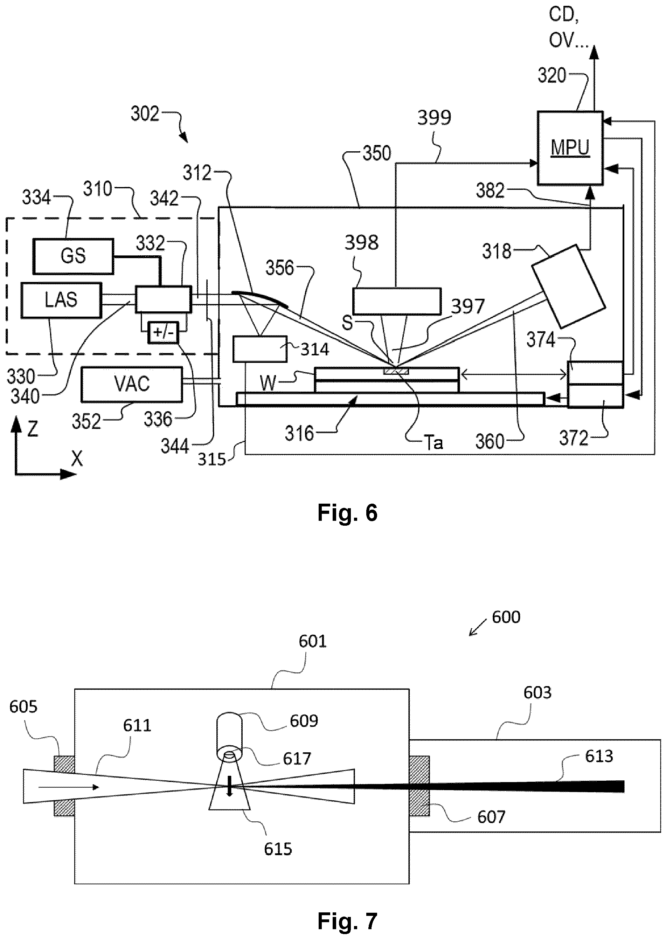

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to $10\mu m$, for example in the region of $1\mu m$ (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen ($N_2$), Oxygen ($O_2$), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 $\mu$m in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV SXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV, SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which a gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation may be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

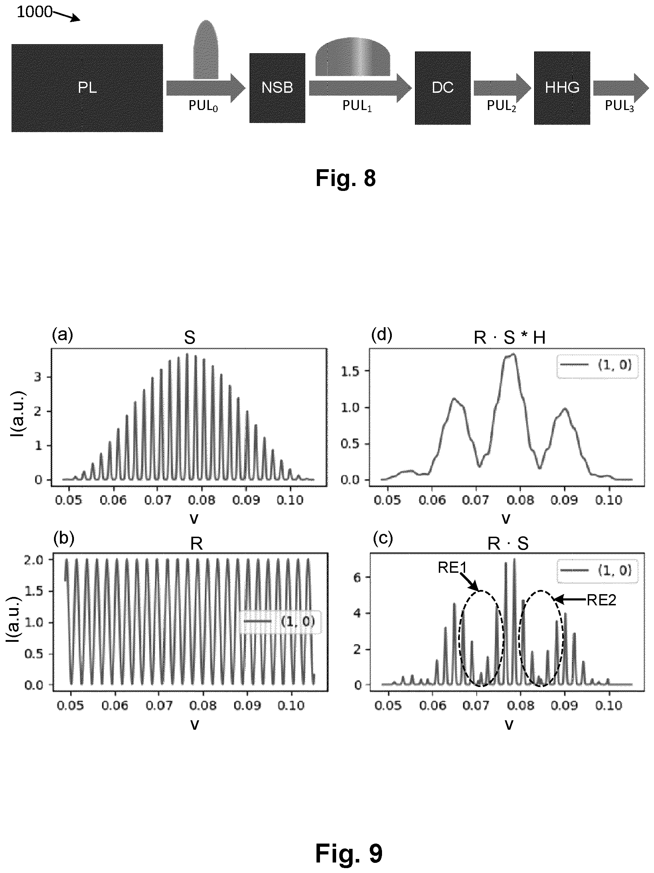

Figure 8 depicts a schematic representation of an illumination source configured in a first configuration where a single spectrum is provided for metrology. In one embodiment, the schematic representation shows a SXR illumination source configured in the first configuration where a single SXR spectrum is provided for SXR metrology.

The SXR illumination source 1000 comprises a drive or pump laser PL configured to provide a drive or pump radiation laser beam comprising a train of pump pulses $PUL_0$, which may be one embodiment of the pump radiation 611 shown in Figure 7. In an implementation, the pump pulses $PUL_0$ may have a pulse-width of for example 400-500 fs and a center wavelength of for example around 1030 nm. Such pump pulses $PUL_0$ may be provided by for example an Ytterbium based laser.

The SXR illumination source 1000 further comprises a nonlinear spectral broadening unit NSB configured to spectrally broaden the pump pulses $PUL_0$ to obtain spectrally broadened (or broadband) pump pulses $PUL_1$. The nonlinear spectral broadening unit NSB may comprise a gas-filled multi-pass cell (MPC), a solid-core multi-pass cell, or a gas-filled hollow-core photonic crystal fiber (HC-PCF). One embodiment of MPC is described in patent applications WO2022228820A1 incorporated herein by reference in its entirety.

The SXR illumination source 1000 further comprises a dispersion compensation unit DC configured to temporally compress the spectrally broadened pump pulses $PUL_1$ to obtain temporally compressed pump pulses $PUL_2$. The dispersion compensation unit DC may comprise for example dispersive mirrors, gratings, or the combination thereof.

In one embodiment, the SXR illumination source 1000 further comprises a HHG unit configured to convert the temporally compressed pump pulses $PUL_2$ to SXR pulses $PUL_3$. In HHG, the temporally compressed pump pulses $PUL_2$ are focused into a gas target, after which the gas atoms convert part of the pump radiation $PUL_2$ to SXR pulses $PUL_3$. For this process to be sufficiently efficient, it is important that the pump pulses $PUL_2$ are sufficiently short, typically shorter than 50 fs, or around 35 fs for example. In an implementation, the HHG unit may comprise the illumination source 600 shown in Figure 7, wherein the temporally compressed pump pulses $PUL_2$ may be used as the pulsed pump radiation 611 for HHG. The SXR pulses $PUL_3$ emitted from the HHG unit may cover a wavelength range for example between 10 nm and 20 nm. Such SXR pulses $PUL_3$ will be guided into a metrology apparatus (e.g., the spectroscopic scatterometer of the metrology apparatus 302 of Figure 6) for SXR metrology.

While specific embodiments have been described on HHG source for SXR generation, it will be appreciated that the invention, where the context allows, may be practiced with other types of sources for SXR generation, as well as sources for generating illumination or radiation with a different wavelength. For example this invention may be implemented into a laser produced plasma (LPP) source, optionally a Xe-based LPP source. For example this invention may be implemented into a LPP source for generating SXR illumination with 1-20 nm wavelength.

In the embodiment of SXR metrology using HHG source, a target is illuminated by a broadband spectrum of SXR radiation. The resultant diffraction pattern is captured by a sensor (e.g., the detection system 398) and is subsequently analyzed by a processor (e.g., the processor 320) such that estimates of parameters of interest, such as overlay (OVL) and critical dimension (CD), can be obtained. In principle, the diffraction pattern can be mapped to diffraction spectra $I_{m\lambda}(m_x, m_y, \lambda)$ where $m_x$, $m_y$ are discrete diffraction order numbers and $\lambda$ is the wavelength, or alternatively as $I_{m\nu}(m_x, m_y, \tilde{\nu})$ where $\tilde{\nu} = 1/\lambda$ is the wavenumber.

Figure 9(a) shows an example source spectrum S emitted from a SXR illumination source (e.g., as shown in Figure 8). Figure 9(b) shows an example response spectrum R of a target. As shown in Figure 9(a), the source spectrum S is comb-like with peaks at wavenumbers $\tilde{\nu} = n\tilde{\nu}_d$, where $\tilde{\nu}_d$ is the wavenumber of the pulsed pump radiation and n is an odd number, also called the harmonic number. Thus, the wavenumbers $\tilde{\nu}$ of the source spectrum S are odd harmonics of the pump wavenumber $\tilde{\nu}_d$ (hereafter: "odd harmonics"). The comb-like source spectrum implies that the wavenumber spectrum is effectively sampled at discrete wavenumber values, which means that Nyquist limit applies. This Nyquist limit can be interpreted as a 'Nyquist distance' which can be expressed as:

$$Z_{\text{Nyq}} = (8\tilde{\nu}_d \cos\vartheta)^{-1}, \qquad [1]$$

where $\vartheta$ is the angle of incidence. If z is the direction normal to the target surface, it means that the response R (i.e. diffraction efficiency) of the target (e.g., as shown in Figure 9(b)) related to features in the target with distances or depths $\Delta z > Z_{\text{Nyq}}$ may be difficult to distinguish from those of features with distances $\Delta z < Z_{\text{NYq}}$. This is the aliasing effect of a sampled signal, where $\Delta z$ is analogous to frequency in the more conventional description of signal sampling in the time domain. In practice, this means that there may be ambiguity in the signals coming from a target stack thicker than the 'Nyquist distance' $Z_{\text{Nyq}}$. For example, in the case where the wavenumber of the pulsed pump radiation is 0.97 $\mu$m$^{-1}$ and the angle of incidence is 30 degrees, the 'Nyquist distance' is approximately 150 nm. Accordingly, stack features with larger distances $\Delta z > 150$ nm may be difficult to distinguish from features with shorter distances $\Delta z < 150$ nm, thus resulting in measurement errors. Figures 9(c) shows an example measured spectrum $R \cdot S$ that is not convolved with a point-spread function associated with the SXR radiation beam (see below). As shown in Figure 9(c), intensities at certain wavenumbers e.g., in the first region RE1 and the second region RE2, are suppressed as a result of the aliasing effect. Note that without the aliasing effect, the 'ideal' spectrum $R \cdot S$ may preserve the shape of the source spectrum shown in Figure 9(a).

In addition, the divergence of the SXR radiation beam translates into the observable diffraction spectrum $I_{m\lambda}$ being blurred with a point-spread function having a full width half maximum (FWHM) that corresponds to the divergence of the SXR radiation beam. Figure 9(d) shows an example measured spectrum $R \cdot S * H$ that is a result of the spectrum $R \cdot S$ shown in Figure 9(c) being convolved with a point-spread function $H$ (not shown in the figure) associated with the SXR radiation beam. Note that such a convolved spectrum $R \cdot S * H$ is what would be captured by a sensor. Note that these examples are not real measurements but illustrations to bring the point across. As shown in Figure 9(d), the periodic discrete peaks of the spectrum $R \cdot S$ are no longer resolvable as a result of the blurring effect. Such blurring of the SXR spectrum tends to reduce the measurement sensitivity for features with distances larger than sensitivity distance $Z_{sen}$, i.e. $\Delta z > Z_{sen}$. The sensitivity distance $Z_{sen}$ is inversely proportional to the full width at half maximum (FWHM) of the point-spread function and the target pitch size. In other words, both a larger FWHM of the point-spread function and a larger target pitch size may result in a proportionally smaller sensitivity distance $Z_{sen}$. For example, in the case where the target pitch size is 70 nm and the FWHM of the point-spread function is about 0.1 nm, the blurring of the SXR spectrum results in a sensitivity distance $Z_{sen}$ of about 250 nm. Accordingly, the measurement sensitivity for stack features with larger distances $\Delta z > 250$ nm is reduced as compared to features with smaller distances $\Delta z < 250$ nm.

It has been found that the combined effect of a comb-like illumination spectrum and blurring thereof increases the measurement sensitivity at larger distances $\Delta z > Z_{sen}$. However, such a combination does not resolve the signal ambiguity issue resulting from the Nyquist aliasing. Therefore, it is desirable to remove the Nyquist aliasing so as to improve the accuracy of SXR metrology.

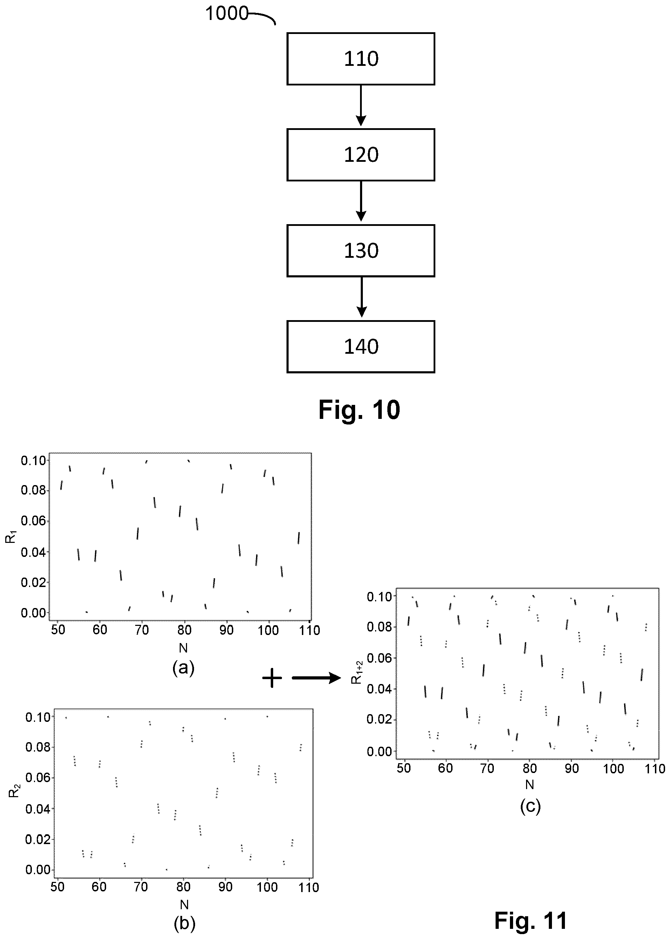

Accordingly, in an aspect of the present disclosure, there is provided a method for improving accuracy of SXR metrology. Figure 10 shows a flow diagram of steps in a method 1000 for improving accuracy of SXR metrology, in accordance with an embodiment. The method 1000 may comprise four main steps 110-140 and may be executed by a processor in a metrology or inspection apparatus.

Step 110: obtaining a first diffraction spectrum and a second diffraction spectrum; e.g., this may be obtained as a result of illuminating a target structure with respectively a first source spectrum and a second source spectrum, either sequentially or simultaneously; wherein at least the first source spectrum comprises a plurality of periodic discrete peaks and wherein the first source spectrum (e.g., as shown in Figure 9(a)) and the second source spectrum are complementary to each other.

Note that the first source spectrum and the second source spectrum are complementary as long as one of the first source spectrum and the second source spectrum comprises spectral components that can (at least substantially) fill at least part of the gaps (e.g., between any two neighboring discrete peaks) in the other one of the first source spectrum and the second source spectrum. In some embodiments, the first source spectrum and the second source spectrum may comprise some overlapping spectral components. For example, the first source spectrum may have gaps in some wavelength range and may be continuous in the other wavelength range, whereas the second source spectrum may be continuous in the wavelength range where the first source spectrum have gaps and may have gaps in the other wavelength range where the first source spectrum is continuous. Here, a gap in a spectrum means one or more integer multiples of the center wavenumber of the pulsed pump radiation that are comprised within the spectrum have substantially zero intensity values (substantially zero may be zero ignoring or discounting noise). Thus, a gap-free spectrum means all of the integer multiples of the center wavenumber of the pulsed pump radiation that are comprised within the spectrum have non-zero intensity values. By comparison, a continuous spectrum means all of the wavenumbers that are comprised within the spectrum have non-zero intensity values.

The first source spectrum and the second source spectrum may each overlap partially with the range of 1 nm to 50 nm, or 5 nm to 40 nm, or 5 nm to 30 nm, or 10 nm to 20 nm.

In some implementations, the first diffraction spectrum and the second diffraction spectrum may each comprise a convolved diffraction spectrum captured (e.g., directly) by a detection system (e.g., the detection system 398) of a metrology apparatus (e.g., the metrology apparatus 302). As such, the first diffraction spectrum and the second diffraction spectrum may both be blurred by the above-described blurring effect (a result of the respective spectrum being convolved with a point-spread function associated with the SXR radiation beam (e.g., as shown in Figure 9(d))). In some implementations, the first diffraction spectrum and the second diffraction spectrum may each comprise a deconvolved diffraction spectrum as determined using a processor (e.g., the processor 320) of the metrology apparatus. In operation, upon capturing the convolved diffraction spectrum, the detection system of the metrology apparatus may be operable to send the convolved diffraction spectrum to the processor which processes the convolved diffraction spectrum to remove the blurring effect, i.e. to deconvolve each spectrum from the associated point-spread function (with the result of the deconvolution, e.g., as shown in Figure 9(c)).

In some implementations, the first source spectrum and the second source spectrum may each comprise a plurality of periodic discrete peaks. Here, the term "periodic" means recurring at regular intervals. In some implementations, the plurality of periodic discrete peaks of the first source spectrum may be located at only odd harmonics of a center wavenumber of the pulsed pump radiation and the plurality of periodic discrete peaks of the second source spectrum may be located at only even harmonics of the center wavenumber of the pulsed pump radiation. In some implementations, the plurality of periodic discrete peaks of the first source spectrum may be located at only odd harmonics of the center wavenumber of the pulsed pump radiation and the plurality of periodic discrete peaks of the first source spectrum may be located at both odd and even harmonics of the center wavenumber of the pulsed pump radiation.

In some implementations, the first source spectrum may comprise a plurality of periodic discrete peaks located at only odd harmonics of the center wavenumber of the pulsed pump radiation and the second source spectrum may comprise a continuous spectrum.

Step 120: determining a first response spectrum and a second response spectrum of the target structure based on the first source spectrum and the first diffraction spectrum, and on the second source spectrum and the second diffraction spectrum, respectively.

In some implementations, the response spectrum of a target structure may be determined by dividing the first (or second) diffraction spectrum by the first (or second) source spectrum and can be expressed as:

$$R_i(\tilde{v}) = I_i(\tilde{v})/S_i(\tilde{v}), \qquad\qquad [2]$$

where $I_i(\tilde{v})$ denotes the diffraction spectrum, $S_i(\tilde{v})$ denotes the source spectrum, $\tilde{v}$ denotes the wavenumber of the SXR radiation beam, and $i = 1, 2$. Here, the diffraction spectrum $I_i(\tilde{v})$ may either be convolved with or deconvolved from the point-spread function. In the context of the present disclosure, it is assumed that the point spread function has a constant shape or width across the spectrum. Hence, the response spectrum describes the diffraction efficiency of the target structure at each constituent wavenumber $\tilde{v}$ of the source spectrum.

Accordingly, the first response spectrum $R_1(\tilde{v})$ of the target structure may be determined by dividing the first diffraction spectrum $I_i(\tilde{v})$ by the first source spectrum $S_1(\tilde{v})$ and the second response spectrum $R_2(\tilde{v})$ may be determined by dividing the second diffraction spectrum $I_2(\tilde{v})$ by the second source spectrum $R_2(\tilde{v})$. It will be appreciated that a comb-like source spectrum $S_i(\tilde{v})$ (e.g., as shown in Figure 9(a)) may comprise zeros or near-zeros at certain wavenumbers (e.g.,

between two neighboring discrete peaks), causing certain portions of the response spectrum $R_i(\tilde{\nu})$ to be undefined or at least highly inaccurate for those wavenumbers and consequently resulting in measurement errors.

Figures 11(a) and 11(b) show respectively an example first response spectrum $R_1(\tilde{\nu})$ and an example second response spectrum $R_2(\tilde{\nu})$, each of which may have been obtained by dividing a measured/processed diffraction spectrum $I_i(\tilde{\nu})$ by a corresponding source spectrum $S_i(\tilde{\nu})$. The x-axis (or horizontal axis) and y-axis (or vertical axis) of each response spectrum represent the harmonic number (integer multiples of the pump wavenumber) and the response, respectively. In the first response spectrum $R_1(\tilde{\nu})$ of Figure 11(a), responses (e.g., diffraction efficiencies of the target structure) at odd harmonics are well-defined and accurate whereas responses (e.g., diffraction efficiencies of the target structure) at even harmonics are either undefined or highly inaccurate (e.g., off-scale values as a result of even harmonics of the source spectrum having zero or close to zero intensities). It will be appreciated that the response spectrum $R_i(\tilde{\nu})$ of the target structure can be of any (regular or irregular) shape depending on the specific arrangement of the target structure.

Step 130: combining the first response spectrum with the second response spectrum to construct an improved response spectrum having fewer gaps than the first response spectrum.

In some implementations, the step of combining the first response spectrum with the second response spectrum may comprise: comparing the value of the first SXR response spectrum at a given wavenumber with the value of the second SXR response spectrum at the same wavenumber to determine which one of the two values is more accurate; repeating the above step for all the wavenumbers (including odd harmonics and even harmonics of the first or second SXR response spectrum, and using the determined most accurate values to construct the improved response spectrum.

By way of example and with continued reference to Figures 11(a) and 11(b), for odd harmonics, the first response spectrum $R_1(\tilde{\nu})$ has well-defined and thus more accurate response values, whereas for even harmonics, the second response spectrum $R_2(\tilde{\nu})$ has well-defined and thus more accurate response values. Therefore, when combining the first response spectrum $R_1(\tilde{\nu})$ with the second response spectrum $R_2(\tilde{\nu})$, response values at odd harmonics of the first response spectrum $R_1(\tilde{\nu})$ and response values at even harmonics of the second response spectrum $R_2(\tilde{\nu})$ are used to construct the improved response spectrum $R_{1+2}(\tilde{\nu})$, as shown in Figure 11(c). Here, a response spectrum is improved as long as it has fewer gaps than the first response spectrum. The response spectrum can be either a comb-like spectrum, a continuous spectrum, or a partially continuous spectrum (i.e. comprising both discrete and continuous wavenumbers).

In some cases, the improved response spectrum may still have one or more remaining gaps. Such remaining gaps can be filled through interpolation. In some cases, the improved response spectrum may be a gap-free response spectrum, i.e. all of the integer multiples of the center wavenumber of the pulsed pump radiation that are comprised within the spectrum have accurate response values. In some cases, the improved response spectrum may have fewer values at integer multiples of the center wavenumber which have a response value below a threshold.

The above-described spectrum-combining step 130 is particularly suitable for the case where each of the first source spectrum and the second source spectrum comprises a plurality of periodic discrete peaks. However, in the case where the first source spectrum comprises odd harmonics of the center wavenumber of the pulsed pump radiation and the second source spectrum comprises a continuous spectrum, the combining step 130 may further comprise subtracting the first response spectrum $R_1(\tilde{\nu})$ from the second response spectrum $R_2(\tilde{\nu})$ to obtain a third response spectrum $R_3(\tilde{\nu}) = R_2(\tilde{\nu})\text{-}R_1(\tilde{\nu})$, said third response spectrum $R_3(\tilde{\nu})$ comprising information predominantly about response at even harmonics of the center wavenumber of the pulsed pump radiation. Then, response values at odd harmonics of the first response spectrum $R_1(\tilde{\nu})$ and response values at even harmonics of the third response spectrum $R_3(\tilde{\nu})$ are used to construct an improved response spectrum $R_{1+3}(\tilde{\nu})$ (not shown), in a similar manner as described above in relation to Figure 11(a)-11(c).

In some implementations, before the step of subtracting the first response spectrum $R_1(\tilde{\nu})$ from the second response spectrum $R_2(\tilde{\nu})$ to obtain the third response spectrum $R_3(\tilde{\nu})$, the method 1000 may further comprise normalizing one or both of the first response spectrum and the second response spectrum.

Step 140: determining a property of interest of the target structure using the improved response spectrum. The properties of interest of the target structure may comprise overlay errors between subsequent layers, line thicknesses, critical dimensions (CD), shape of structures, etc.

Although the first source spectrum and the second source spectrum may be provided by two separate SXR illumination sources, it is preferable that the two spectra are provided by a single SXR illumination source to lower complexity and cost. Therefore, various methods for varying the output spectrum of the SXR illumination source (e.g., as shown in Figure 8) are proposed hereinafter.

In one embodiment, the method comprises measuring a structure with a first radiation generated with a first spectrum to obtain a first measured signal, and measuring the structure with a second radiation to obtain a second measured signal. Optionally measuring the structure with the second radiation to obtain the second measured signal is subsequent to measuring a structure with a first radiation generated with a first spectrum to obtain a first measured signal. Optionally the second spectrum is different from the first spectrum. Optionally the second spectrum is generated by varying at least one of the pump beam and the medium. Optionally the medium is a gas medium. The method further comprises combing the first measured signal and the second measured signal to obtain a parameter of interest of the structure. Optionally the first radiation is generated via an interaction between the pump beam and the medium. Optionally the second radiation is generated via the interaction between the pump beam and the medium. Optionally both the first radiation and the second radiation are generated via the interaction between the pump beam and the medium. Optionally the interaction is a HHG process. Optionally the step of varying at least one of the pump beam and the medium comprises changing material composition of the medium. Optionally the step of varying at least one of the pump beam and the medium comprises shifting the center wavelength of the pump beam.

## First type: the first source spectrum comprises periodic discrete peaks at only odd harmonics and the second source spectrum comprises periodic discrete peaks at only even harmonics

Referring back to Figure 8, one method for obtaining such two complementary spectra from the single SXR illumination source may be to shift the center wavelength of the pump pulses $PUL_0$. When the wavelength of the pump pulses $PUL_0$ is shifted, the resultant second source spectrum is still a comb-like spectrum comprising a plurality of periodic discrete peaks located at only odd harmonics of the shifted pump wavelength. However, if such a wavelength shift is chosen well, the peaks of the second source spectrum can coincide with the valleys of the first source spectrum, thus forming a complementary source spectrum. Therefore, the second source spectrum can be considered as comprising periodic discrete peaks located at only even harmonics of the non-shifted pump wavelength. The wavelength-shifted pump pulses $PUL_0$ may then go through the nonlinear spectral broadening unit NSB for spectral broadening, the dispersion compensation unit DC for pulse compression and the HHG unit for SXR generation (i.e. to generate SXR pulses with complementary spectra). For example, by shifting the wavelength of the pulsed pump radiation between 1037 nm and 1023 nm, the corresponding odd harmonics in the range of 10 nm - 20 nm will be interleaved.

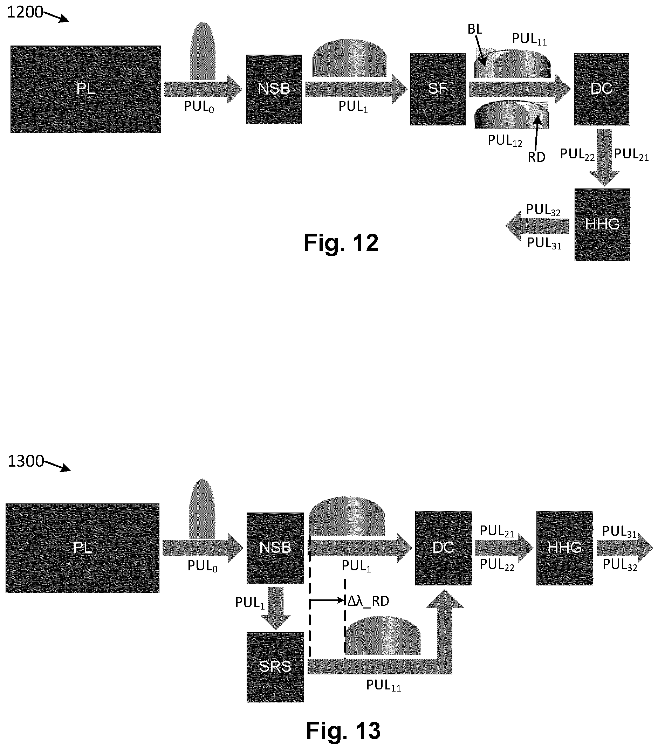

With reference to Figure 12, a different method for obtaining two complementary spectra from the single SXR illumination source 1200 may be to add a spectral filter SF between the nonlinear spectral broadening unit NSB and the dispersion compensation unit DC to spectrally shape broadband pump pulses $PUL_1$, thereby shifting their center wavelength. The spectral filter SF may be a mechanical spectral filter (e.g., a knife edge) configured to filter out or block the blue (e.g., BL) or red (e.g., RD) spectral side of each spectrally broadened pulse $PUL_1$ so as to shift its center wavelength. The wavelength-shifted broadband pulses $PUL_{11}$ and $PUL_{12}$ may then go through the dispersion compensation unit DC for pulse compression (i.e. to generate temporally compressed pulses $PUL_{21}$ and $PUL_{22}$) and the HHG unit for SXR generation (i.e. to generate SXR pulses $PUL_{31}$ and $PUL_{32}$ with complementary source spectra).

With reference to Figure 13, another method for obtaining two complementary spectra from the single SXR illumination source 1300 may comprising using a stimulated Raman scattering unit SRS to induce a red-shift $\Delta\lambda\_RD$ of part (via beam splitting) of each broadband pump pulse $PUL_1$ towards the longer wavelengths $PUL_{11}$. Alternatively, the SXR illumination source 1300 may be operable to switch the optical path of the broadband pump pulse $PUL_1$ such that the broadband pump pulse $PUL_1$ passes through the stimulated Raman scattering unit SRS. The stimulated Raman scattering process may be described as the loss of energy from the laser photons to rotational modes within the molecules, which results in a red-shift of the photons towards longer wavelengths. This so-called Stokes shift may repeat multiple times in a sufficiently long medium and for sufficiently strong laser pulses, and occurs on top of the usual Kerr nonlinearity.

In the example configuration of Figure 13, the nonlinear spectral broadening unit NSB may comprise only a noble gas or gas mixture (predominantly for spectral broadening); whereas the stimulated Raman scattering unit SRS may comprise a molecular gas (e.g., nitrogen) filled gas cell, or a molecular gas filled HC-PCF (predominantly for stimulated Raman scattering based red-shift). For the purpose of shifting the wavelength of broadband pump pulses $PUL_{11}$ to fill the gaps between the odd harmonics, a wavelength shift $\Delta\lambda\_RD$ of approximately 15 nm may be sufficient. The wavelength-shifted broadband pulses $PUL_1$ and $PUL_{11}$ may then go through the dispersion compensation unit DC for pulse compression (i.e. to generate temporally compressed pulses $PUL_{21}$ and $PUL_{22}$) and the HHG unit for SXR generation (i.e. to generate SXR pulses $PUL_{31}$ and $PUL_{32}$ with complementary source spectra).

In a variant configuration, an additional stimulated Raman scattering unit SRS may not be required. Instead, the nonlinear spectral broadening unit NSB may be operable to provide both spectral broadening and stimulated Raman scattering (on demand) to the input pump pulses $PUL_0$. For example, when a wavelength shift is desired, a small amount of a molecular gas or gas mixture may be controllably added to the nonlinear spectral broadening unit NSB (which otherwise is usually filled with a noble gas). The resultant noble and molecular gas mixture may induce both the required spectral broadening and the required stimulated Raman scattering based red-shift.

In another variant configuration, the SXR illumination source may comprise two parallel spectral broadening gas cells where a first gas cell is filled with only a noble gas or gas mixture and a second gas cell with an appropriate mixture of a noble gas or gas mixture and a molecular gas or gas mixture. When no wavelength shift is desired, the SXR illumination source may be operable to pass the pump pulses $PUL_0$ through the first spectral broadening gas cell. When a wavelength shift is desired, the SXR illumination source may be operable to change the optical path such that the pump pulses $PUL_0$ pass through the second spectral broadening gas cell.

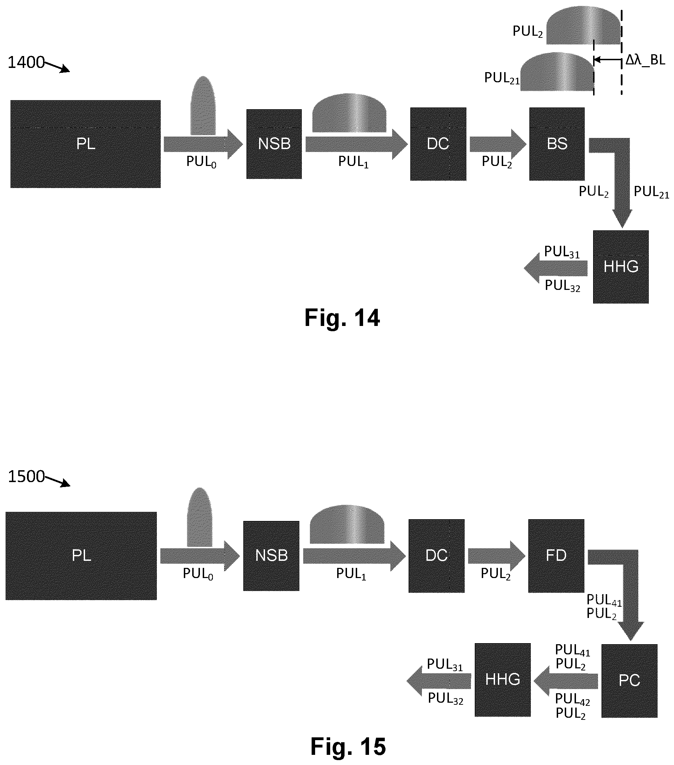

With reference to Figure 14, another different method for obtaining two complementary spectra from the single SXR illumination source 1400 may comprise using a blue-shifting gas cell BS between the dispersion compensation unit DC and the HHG unit. The blue-shifting gas cell BS may be configured to induce a blue-shift $\Delta\lambda\_BL$ of each temporally compressed pump pulse $PUL_{21}$ towards the shorter wavelengths. The desired wavelength blue-shift $\Delta\lambda\_BL$ may result from rapid plasma formation, where photon-ionization arises from the direct electric field of the temporally compressed pump pulse $PUL_2$. Typically, when an intense femtosecond laser pulse propagates through a gaseous medium, the resulting optical-field-introduced ionization leads to a rapid increase in the electron density, which corresponds to a decrease in the plasma refractive index. Such a blue-shifted temporally compressed pump pulse $PUL_{21}$ then propagates through the gas jet of the HHG unit and generates correspondingly blue-shifted SXR spectrum $PUL_{32}$ (i.e. the second source spectrum). The non-shifted temporally compressed pump pulse $PUL_2$ leads to the generation of the non-shifted SXR spectrum $PUL_{31}$ (i.e. the first source spectrum).

The amount of the blue-shift $\Delta\lambda\_BL$ in the SXR spectrum can be continuously tuned by changing the parameters of the gas cell, e.g., gas pressure or gas species with different ionization potential, which can be analytically described in the following equation:

$$\Delta\lambda\_BL \sim \frac{zr_e}{2\pi c}\lambda^3 \frac{dn_e}{dt}, \qquad\qquad [3]$$

where z denotes the gas cell length, $r_e$ denotes the classical electron radius, c denotes the speed of light, $n_e$ is the electron density introduced in the plasma.

**Second type: the first source spectrum comprises only odd harmonics and the second source spectrum comprises odd and even harmonics**

Such two complementary SXR spectra may be generated using a two-color HHG process. With reference to Figure 15, the SXR illumination source 1500 may comprise a frequency doubling unit FD and a polarization controlling unit PC placed between the dispersion compensation unit DC and the HHG unit. As such, the fundamental beam comprising temporally compressed pump pulses $PUL_2$ with a fundamental wavelength (e.g., 1030 nm) may be frequency doubled (e.g., via a frequency doubling crystal) to generate a second harmonic beam comprising pulses $PUL_{41}$ with a second harmonic wavelength (e.g., 515 nm). The polarization controlling unit PC may be configured to control the polarization state of the fundamental beam and/or the second harmonic beam. In an implementation, the polarization controlling unit PC may comprise one or more wave-plates (e.g., a half wave-plate). Both beams are temporally and spatially overlapped at the gas target of the HHG unit to generate a SXR beam. When both the fundamental beam $PUL_2$ and the second harmonic beam $PUL_{41}$ have the same polarization state (e.g., p-polarization), the generated SXR spectrum $PUL_{31}$ may only comprise periodic discrete peaks at odd harmonics (i.e. the first source spectrum). However, when the fundamental beam (e.g., p-polarization) $PUL_2$ and the second harmonic beam (e.g., s-polarization) $PUL_{42}$ are orthogonally polarized, the generated SXR spectrum $PUL_{32}$ may comprise both odd and even harmonics (i.e. the second source spectrum).

The setup may be designed such that the polarization controlling unit PC (e.g., a wave-plate) after the frequency doubling unit FD can change the polarization of the second harmonic beam e.g., from s-polarization to p-polarization, but at the same time substantially maintain the polarization of the fundamental beam (e.g., p-polarization). By rotating the wave-plate, it is possible to controllably vary the polarization of the second harmonic beam, thereby switching the SXR spectrum $PUL_{31}$ and $PUL_{32}$.

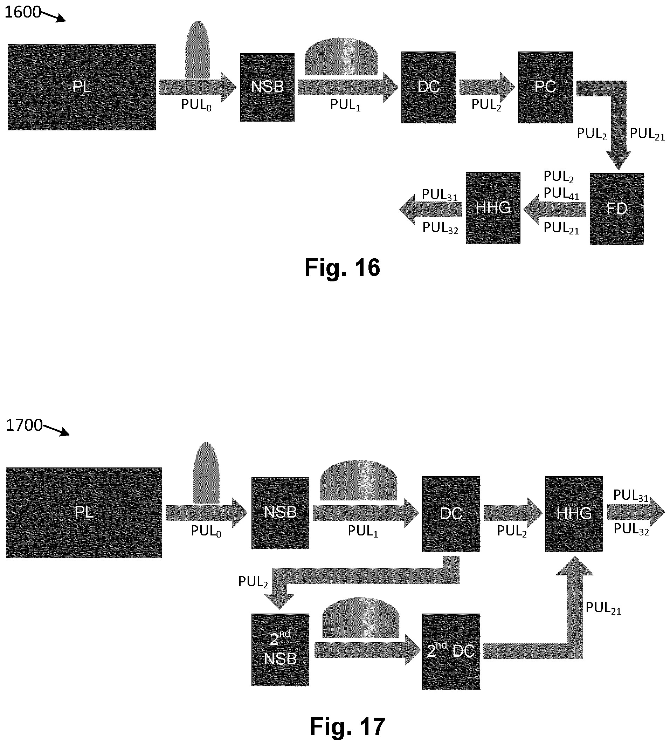

With reference to Figure 16, the SXR illumination source 1600 may also comprise a frequency doubling unit FD and a polarization controlling unit PC, e.g., placed between the dispersion compensation unit DC and the HHG unit. However, in this configuration, the polarization controlling unit PC may be placed upstream the frequency doubling unit FD, rather than downstream the frequency doubling unit FD as shown in the configuration 1500 of Figure 15. The polarization controlling unit PC (e.g., a wave-plate) may be operable to change the polarization of the fundamental beam to phase-match the frequency doubling process or completely phase-mismatch the process. When phase-matched, both the fundamental beam $PUL_2$ (polarized in one polarization state) and the second harmonic beam $PUL_{41}$ can be obtained; whereas when phase-mismatched, only the fundamental beam $PUL_{21}$ (polarized in the orthogonal polarization state) can be obtained. The SXR spectrum $PUL_{31}$ generated by the temporally and spatially overlapped fundamental beam $PUL_2$ and second harmonic beam $PUL_{41}$ may comprise both odd and even harmonics, while the SXR spectrum $PUL_{32}$ generated by the fundamental beam $PUL_{21}$ alone may comprise only odd harmonics. Therefore, by adjusting the polarization controlling unit PC, it is possible to controllably vary the frequency doubling process, thereby switching the SXR spectrum $PUL_{31}$ and $PUL_{32}$.

**Third type: the first source spectrum comprises only odd harmonics and the second source spectrum comprises a continuous spectrum**

The physical reason that the SXR spectrum from HHG is usually peaked into discrete odd harmonics of the pump wavelength (or wavenumber) is that the SXR light is generated in short bursts emitted every half period of the pulsed pump radiation. The interference of this 'burst train' is constructive at frequencies which are the odd harmonics of the pump wavelength (or wavenumber), but destructive in between. The longer the pump pulse, the longer the train of SXR bursts, and the narrower the harmonics become. Conversely, for very short pump laser cycles, there are only a few bursts of SXR generated, resulting in very broad harmonics. In the extreme of pump pulses that are shorter than 2 cycles, the gaps between the harmonics become completely filled, resulting in a broad continuous rather than discrete spectrum. Therefore, one can switch between a continuous and comb-like spectrum by changing the pulse width of the pump pulse.

Conventionally, pump pulses for HHG are moderately compressed to the 25 fs - 50 fs range in a first compression stage (comprising the nonlinear spectral broadening unit NSB and the dispersion compensation unit DC as shown in Figure 8), which results in the comb-like SXR spectrum (e.g., as shown in Figure 9(a)). A switch to a continuous SXR spectrum would require enabling a second compression stage to compress the pulses to less than 5-10 fs, depending on the wavelength of the pulsed pump radiation. Similar to the first compression stage, the second compression stage may comprise a nonlinear medium that increases the spectral bandwidth of the pump pulses, and dispersive optics to overlap all frequency components in time. A geometry that includes many mirror reflections may not work, because current state of the art mirror coatings do not support the required high reflectivity of a sufficiently large bandwidth. Alternatively, metal mirrors have larger bandwidth but suffer from a relatively poor reflectivity. This rules out the multi-pass cell geometry. More suitable option is a geometry with a single pass, such as a HC-PCF. The main challenge for such a pulse compression stage to the few-cycle regime is to limit the loss of pulse energy. The loss issue may be solved by using stretched flexible hollow-core fibers, which have reported transmission of more than 90%.

With reference to Figure 17, the SXR illumination source 1700 may comprise a second compression stage placed downstream the conventional first compression stage. The second compression stage may comprise a second nonlinear spectral broadening unit 2nd NSB and a second dispersion compensation unit 2nd DC. When a comb-like spectrum is desired, the temporally compressed pump pulses $PUL_2$ may be directed to the HHG unit without passing through the second compression stage. As such, the generated SXR spectrum may comprise only odd harmonics (i.e. the first source spectrum). By contrast, when a continuous spectrum is desired, the temporally compressed pump pulses $PUL_2$ may be redirected (e.g., by moving a mirror) to go through the second compression stage to obtain further compressed pump pulses $PUL_{21}$. Such further compressed pump pulses $PUL_{21}$ may then be directed to the HHG unit to generate the continuous SXR spectrum (i.e. the second source spectrum). When switching between the two modes, it may be desirable to compensate for the different pulse lengths so as to keep the laser intensity optimal at the gas target in both situations. This may be done by appropriately adjusting the beam sizes in both arms. Similarly, other properties of the pump pulse may change due to the switch, such as the total pulse energy or beam quality. In this case, it may be desirable to additionally compensate for these collateral changes by means of additional optics in the two compression stages.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses (clause set A):

1. A method for improving accuracy of SXR metrology, comprising:

obtaining a first diffraction spectrum comprising a plurality of periodic discrete peaks and relating to a target structure having been illuminated with a first source spectrum;

obtaining a second diffraction spectrum relating to said target structure having been illuminated with a second source spectrum, the second source spectrum being complementary to the first source spectrum;

determining a first response spectrum of the target structure based on the first source spectrum and the first diffraction spectrum;

determining a second response spectrum of the target structure on the second source spectrum and the second diffraction spectrum;

combining the first response spectrum with the second response spectrum to construct an improved response spectrum having fewer gaps than the first response spectrum; and

determining a property of interest of the target structure using the improved response spectrum.

2. A method as claimed in clause 1, wherein the first response spectrum of the target structure is determined by dividing the first diffraction spectrum by the first source spectrum and the second response spectrum is determined by dividing the second diffraction spectrum by the second source spectrum.

3. A method as claimed in clause 1 or 2, wherein the step of combining the first response spectrum with the second response spectrum comprises:

comparing a first response value of the first response spectrum at a given wavenumber with a second response value of the second response spectrum at the same wavenumber to determine which one of the first response value and the second response value is more accurate;

repeating the above step for every wavenumber of the first response spectrum; and

constructing the improved response spectrum using the determined more accurate values.

4. A method as claimed in any preceding clause, wherein the second response spectrum of the target structure is determined by dividing the second diffraction spectrum by the second source spectrum

5. A method as claimed in any preceding clause, further comprising

deconvolving the first diffraction spectrum from a point-spread function associated with the first source spectrum to obtain a first deconvolved diffraction spectrum; and

deconvolving the second diffraction spectrum from a point spread function associated with the second source spectrum to obtain a second deconvolved diffraction spectrum;

wherein the first response spectrum of the target structure is determined based on the first source spectrum and the first deconvolved diffraction spectrum;

wherein the second response spectrum of the target structure is determined based on the second source spectrum and the second deconvolved diffraction spectrum; and

wherein the resultant improved response spectrum is a deconvolved improved response spectrum.

6. A method as claimed in clause 5, wherein the property of interest of the target structure is determined using the deconvolved improved response spectrum.

7. A method as claimed in any preceding clause, wherein the first source spectrum and the second source spectrum are provided by a single SXR illumination source configured to convert a pulsed pump radiation to a SXR radiation via high harmonic generation (HHG).

8. A method as claimed in any preceding clause, wherein the first source spectrum and the second source spectrum both comprise a plurality of periodic discrete peaks.

9. A method as claimed in clause 8, wherein the plurality of periodic discrete peaks of the first source spectrum are located at only odd harmonics of a center wavenumber of the pulsed pump radiation and the plurality of periodic discrete peaks of the second source spectrum are located at only even harmonics of the center wavenumber of the pulsed pump radiation.

10. A method as claimed in clause 8, wherein the plurality of periodic discrete peaks of the first source spectrum are located at only odd harmonics of a center wavenumber of the pulsed pump radiation and the plurality of periodic discrete peaks of the first source spectrum are located at both odd and even harmonics of the center wavenumber of the pulsed pump radiation.

11. A method as claimed in any of clauses 1 to 7, where the first source spectrum comprises a plurality of periodic discrete peaks located at only odd harmonics of a center wavenumber of the pulsed pump radiation and the second source spectrum comprises a continuous spectrum.

12. A method as claimed in any of clauses 10 or 11, wherein the step of determining a second response spectrum of the target structure comprises:

dividing the second diffraction spectrum by the second source spectrum to obtain an intermediate response spectrum;
subtracting the first response spectrum from the intermediate response spectrum to obtain the second response spectrum, said second response spectrum comprising information predominantly about response at even harmonics of the center wavenumber of the pulsed pump radiation.

13. A method as claimed in any preceding clause, wherein said improved response spectrum comprises fewer values at integer multiples of the center wavenumber which have a response value below a threshold.

14. A method as claimed in any preceding clause, wherein the improved response spectrum is a gap-free response spectrum.

15. A method as claimed in any of clauses 7 to 9, comprising
illuminating the target structure with a first source spectrum and a second source spectrum, either sequentially or simultaneously, to obtain the first diffraction spectrum and the second diffraction spectrum, respectively; and wherein the first source spectrum is generated by:

spectrally broadening the pulsed pump radiation to obtain broadband pulsed pump radiation;
temporally compressing the broadband pulsed pump radiation into compressed pulsed pump radiation; and
subjecting the compressed pulsed pump radiation to a high harmonic generation (HHG) process so as to obtain the first source spectrum.

16. A method as claimed in clause 15, wherein the second source spectrum is generated by:

shifting a center wavelength of the pulsed pump radiation;
spectrally broadening the wavelength-shifted pulsed pump radiation to obtain wavelength-shifted broadband pulsed pump radiation;
temporally compressing the wavelength-shifted broadband pulsed pump radiation into compressed wavelength-shifted pulsed pump radiation; and
subjecting the compressed wavelength-shifted pulsed pump radiation to a high harmonic generation (HHG) process so as to obtain the second source spectrum.

17. A method as claimed in clause 15, wherein the second source spectrum are generated by:

spectrally broadening the pulsed pump radiation to obtain broadband pulsed pump radiation;
shifting a center wavelength of the broadband pulsed pump radiation to obtain wavelength-shifted broadband pulsed pump radiation;
temporally compressing the wavelength-shifted broadband pulsed pump radiation into compressed wavelength-shifted pulsed pump radiation; and
subjecting the compressed wavelength-shifted pulsed pump radiation to a high harmonic generation (HHG) process so as to obtain the second source spectrum.

18. A method as claimed in clause 17, wherein the wavelength shifting of the broadband pulsed pump radiation is achieved by selectively filtering out at least one portion of the broadband pulsed pump radiation.

19. A method as claimed in clause 17, wherein the wavelength shifting of the broadband pulsed pump radiation is achieved via stimulated Raman scattering.

20. A method as claimed in clause 15, wherein the second source spectrum is generated by:

spectrally broadening the pulsed pump radiation to obtain broadband pulsed pump radiation;
temporally compressing the broadband pulsed pump radiation into compressed pulsed pump radiation;
shifting a center wavelength of the compressed pulsed pump radiation to obtain wavelength-shifted compressed pulsed pump radiation; and
subjecting the compressed wavelength-shifted pulsed pump radiation to a high harmonic generation (HHG) process so as to obtain the second source spectrum.

21. A method as claimed in clause 10, comprising:
illuminating the target structure with a first source spectrum and a second source spectrum, either sequentially or simultaneously, to obtain the first diffraction spectrum and the second diffraction spectrum, respectively; and wherein the first source spectrum and the second source spectrum are generated by:

> spectrally broadening the pulsed pump radiation to obtain broadband pulsed pump radiation;
> temporally compressing the broadband pulsed pump radiation into compressed pulsed pump radiation;
> frequency doubling the compressed pulsed pump radiation to obtain second harmonic of the compressed pulsed pump radiation and a remaining part of the compressed pulsed pump radiation, wherein the second harmonic of the compressed pulsed pump radiation is in a first polarization state and the remaining part of the compressed pulsed pump radiation is in a second polarization state;
> switching a polarization state of the second harmonic of the compressed pulsed pump radiation between a first polarization state and a second polarization state while maintaining a second polarization state of the remaining part of the compressed pulsed pump radiation;
> subjecting the second harmonic of the compressed pulsed pump radiation and the remaining part of the compressed pulsed pump radiation, both in the second polarization state, to a high harmonic generation (HHG) process so as to obtain the first source spectrum; and
> subjecting the second harmonic of the compressed pulsed pump radiation in the first polarization state and the remaining part of the compressed pulsed pump radiation in the second polarization state to a high harmonic generation (HHG) process so as to obtain the second source spectrum.

22. A method as claimed in clause 10, wherein the first source spectrum and the second source spectrum are generated by:

> spectrally broadening the pulsed pump radiation to obtain broadband pulsed pump radiation;
> temporally compressing the broadband pulsed pump radiation into compressed pulsed pump radiation;
> switching a polarization state of the compressed pulsed pump radiation between a first polarization state and a second polarization state;
> when the compressed pulsed pump radiation is in a second polarization state, frequency doubling the compressed pulsed pump radiation to obtain second harmonic of the compressed pulsed pump radiation in a first polarization state and a remaining part of the compressed pulsed pump radiation in a second polarization state;
> when the compressed pulsed pump radiation is in a first polarization state, substantially maintaining characteristics of the compressed pulsed pump radiation;
> subjecting the second harmonic of the compressed pulsed pump radiation and the remaining part of the compressed pulsed pump radiation to a high harmonic generation (HHG) process so as to obtain the second source spectrum; and
> subjecting the compressed pulsed pump radiation to a high harmonic generation (HHG) process so as to obtain the first source spectrum.

23. A method as claimed in clause 11, comprising:
illuminating the target structure with a first source spectrum and a second source spectrum, either sequentially or simultaneously, to obtain the first diffraction spectrum and the second diffraction spectrum, respectively; and wherein the second source spectrum is generated by:

> spectrally broadening the pulsed pump radiation to obtain broadband pulsed pump radiation;
> temporally compressing the broadband pulsed pump radiation into first compressed pulsed pump radiation having a spectrum comprising a plurality of periodic discrete peaks;
> spectrally broadening at least part of the first compressed pulsed pump radiation to obtain second broadband pulsed pump radiation;
> temporally compressing the second broadband pulsed pump radiation into second compressed pulsed pump radiation having a continuous spectrum;
> subjecting the first compressed pulsed pump radiation to a high harmonic generation (HHG) process so as to obtain the first source spectrum; and
> subjecting the second compressed pulsed pump radiation to a high harmonic generation (HHG) process so as to obtain the second source spectrum.

24. A method as claimed in clause 23, wherein before the step of subtracting the first response spectrum from the intermediate response spectrum, the method further comprises normalizing one or both of the first response spectrum and the intermediate response spectrum.

25. A method as claimed in any preceding clause, wherein each of the first source spectrum and the second source spectrum overlaps partially with the range of 1 nm to 50 nm.

26. A method as claimed in any preceding clause, wherein each of the first source spectrum and the second source spectrum overlaps partially with the range of 10 nm to 20 nm.

27. A computer program comprising program instructions operable to perform the method of any preceding clause, when run on a suitable apparatus.

28. A metrology tool for measuring and/or inferring properties of a patterned structure on a substrate, comprising a non-transient computer program carrier comprising a computer program as claimed in clause 27.

29. A SXR light source operable to output two complementary spectra, either simultaneously or sequentially, optionally for use in a method as claimed in any of clauses 1 to 26.

30. A light source, comprising:

a pulsed pump radiation source for providing pulsed pump radiation;
a nonlinear spectral broadening unit for spectrally broadening the pulsed pump radiation to obtain spectrally broadened pulsed pump radiation;
a dispersion compensation unit for temporally compressing the spectrally broadened pulsed pump radiation to obtain compressed pulsed pump radiation; and
a high harmonic generation unit for converting the compressed pulsed pump radiation into SXR radiation;
wherein one or more of the pulsed pump radiation source, the nonlinear spectral broadening unit, the dispersion compensation unit and the high harmonic generation unit are configurable to output a first source spectrum and a second source spectrum complementary to the first source spectrum.

31. A light source as claimed in clause 30, wherein the pulsed pump radiation source is operable such that a center wavelength of the pulsed pump radiation source is switchable between a first center wavelength and a second center wavelength, resulting in the first source spectrum and the second source spectrum, respectively.

32. A light source as claimed in any of clauses 30 or 31, wherein the nonlinear spectral broadening unit is operable to generate a first spectrally broadened pulsed pump radiation having a first center wavelength and a second spectrally broadened pulsed pump radiation having a second center wavelength; and wherein the first center wavelength and the second center wavelength are shifted with respective to each other.

33. A light source as claimed in any of clauses 30 or 31, further comprising another nonlinear spectral broadening unit, wherein the nonlinear spectral broadening unit is operable to spectrally broaden at least part of the pulsed pump radiation to output a first spectrally broadened pulsed pump radiation, and the other nonlinear spectral broadening unit is operable to spectrally broaden at least part of the pulsed pump radiation to output a second spectrally broadened pulsed pump radiation, wherein the first spectrally broadened pulsed pump radiation and the second spectrally broadened pulsed pump radiation are spectrally shifted with each other and result in the first source spectrum and the second source spectrum, respectively.

34. A light source as claimed in any of clauses 30 to 33, further comprising a blue-shifting gas cell, wherein the dispersion compensation unit is operable to temporally compress the spectrally broadened pulsed pump radiation to output a first compressed pulsed pump radiation, and the blue-shifting gas cell is operable to induce a blue shift of a center wavelength of at least part of the first compressed pulsed pump radiation to output a second compressed pulsed pump radiation, wherein the first compressed pulsed pump radiation and the second compressed pulsed pump radiation are spectrally shifted with each other and result in the first source spectrum and the second source spectrum, respectively.

Further embodiments are disclosed in the subsequent numbered clauses (clause set B):

1. A method, comprising:

Measuring a structure with a first radiation generated with a first spectrum to obtain a first measured signal, wherein the first radiation is generated via an interaction between a pump beam and a medium,
Varying at least one of the pump beam and the medium to generate a second radiation with a second spectrum, wherein the second spectrum is different from the first spectrum,
Measuring the structure with the second radiation subsequently to obtain a second measured signal, and
Combining the first measured signal and the second measured signal to obtain a parameter of interest of the structure.

2. A method according to clause 1, wherein the first spectrum comprises a plurality of periodic discrete peaks.

3. A method according to clause 1 or 2, wherein the second source spectrum being complementary to the first source spectrum.

4. A method according to any of the preceding clauses, wherein the interaction between the pump beam and the medium is a high harmonic generation process.

5. A method according to any of clauses 1 to 3, wherein the interaction between the pump beam and the medium is a laser produced plasma process.

6. A method according to any of the preceding clauses, wherein the second source spectrum comprises a continuous spectrum.

7. A method according to any of the preceding clauses, wherein the step of varying at least one of the pump beam and the medium comprises shifting a center wavelength of the pump beam.

8. A method according to any of the preceding clauses, wherein the step of varying at least one of the pump beam and the medium comprises changing material composition of the medium.

9. A computer program comprising program instructions operable to perform the method of any preceding clause, when run on a suitable apparatus.

10. A radiation source operable to output two radiation beams with different spectra having wavelengths, optionally in the range from 1 to 50 nm, via an interaction between a pump beam and a medium, wherein the radiation source is configured to vary at least one of the pump beam and the medium to generate the two radiation beams with different spectra.

11. A radiation source according to clause 10, wherein the interaction between the pump beam and the medium is a high harmonic generation process.

12. A radiation source according to clause 10, wherein the interaction between the pump beam and the medium is a laser produced plasma process.

13. A radiation source according to any of clauses 10 to 12, wherein the radiation source is configured to shift a center wavelength of the pump beam.

14. A radiation source according to any of clauses 10 to 13, wherein the radiation source is configured to change material composition of the medium.

15. A radiation source according to any of clauses 10 to 14, further comprises a multi-pass cell.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

**Claims**

1. A method, comprising:

   Measuring a structure with a first radiation generated with a first spectrum to obtain a first measured signal, wherein the first radiation is generated via an interaction between a pump beam and a medium,
   Varying at least one of the pump beam and the medium to generate a second radiation with a second spectrum, wherein the second spectrum is different from the first spectrum,
   Measuring the structure with the second radiation subsequently to obtain a second measured signal, and
   Combining the first measured signal and the second measured signal to obtain a parameter of interest of the structure.

2. A method according to claim 1, wherein the first spectrum comprises a plurality of periodic discrete peaks.

3. A method according to claim 1 or 2, wherein the second source spectrum being complementary to the first source spectrum.

4. A method according to any of the preceding claims, wherein the interaction between the pump beam and the medium is a high harmonic generation process.

5. A method according to any of claims 1 to 3, wherein the interaction between the pump beam and the medium is a laser produced plasma process.

6. A method according to any of the preceding claims, wherein the second source spectrum comprises a continuous spectrum.

7. A method according to any of the preceding claims, wherein the step of varying at least one of the pump beam and the medium comprises shifting a center wavelength of the pump beam.

8. A method according to any of the preceding claims, wherein the step of varying at least one of the pump beam and the medium comprises changing material composition of the medium.

9. A computer program comprising program instructions operable to perform the method of any preceding claim, when run on a suitable apparatus.

10. A radiation source operable to output two radiation beams with different spectra having wavelengths in the range from 1 to 50 nm via an interaction between a pump beam and a medium, wherein the radiation source is configured to vary at least one of the pump beam and the medium to generate the two radiation beams with different spectra.

**11.** A radiation source according to claim 10, wherein the interaction between the pump beam and the medium is a high harmonic generation process.

**12.** A radiation source according to claim 10, wherein the interaction between the pump beam and the medium is a laser produced plasma process.

**13.** A radiation source according to any of claims 10 to 12, wherein the radiation source is configured to shift a center wavelength of the pump beam.

**14.** A radiation source according to any of claims 10 to 13, wherein the radiation source is configured to change material composition of the medium.

**15.** A radiation source according to any of claims 10 to 14, further comprises a multi-pass cell.

**Fig. 1**

LC

SC x 4

**Fig. 2**

DE x 4

LA

SC1

SC3

CL

-1    0    +1

MT

SC2

**Fig. 3**

**Fig. 4**

SM1

**Fig. 5**

SM1

**Fig. 6**

**Fig. 7**

**Fig. 8**

**Fig. 9**

Fig. 10

Fig. 11

1200

**Fig. 12**

1300

**Fig. 13**

**Fig. 14**

**Fig. 15**

1600

Fig. 16

1700

Fig. 17

**Europäisches Patentamt**
**European Patent Office**
**Office européen des brevets**

# EUROPEAN SEARCH REPORT

Application Number

EP 23 18 3484

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/155171 A1 (LIN NAN [NL] ET AL) 23 May 2019 (2019-05-23) | 10,11, 13-15 | INV. G03F7/00 |
| Y | * abstract * | 1-9 | G01N21/956 |
| A | * figures 4,5 * * paragraphs [0002], [0074] - [0091] * | 12 | G02F1/37 H05G2/00 |
| Y | US 2018/220518 A1 (POLYAKOV ALEXEY OLEGOVICH [NL] ET AL) 2 August 2018 (2018-08-02) | 1-9 | |
| A | * abstract * * figures 4,8-10 * * paragraphs [0002], [0065] - [0097], [0117] * | 10-15 | |
| X | US 2023/136618 A1 (KUNG ANDREW HING CHEONG [TW] ET AL) 4 May 2023 (2023-05-04) | 10,11,13 | |
| A | * abstract * * figures 10,11 * * paragraphs [0003], [0096] - [0105] * | 1-9,12, 14,15 | |
| X | CN 105 333 953 A (UNIV HUAZHONG SCIENCE TECH) 17 February 2016 (2016-02-17) | 10,12 | TECHNICAL FIELDS SEARCHED (IPC) |
| A | * the whole document * | 1-9,11, 13-15 | G03F G02F G01N |
| A | WO 2022/228820 A1 (ASML NETHERLANDS BV [NL]) 3 November 2022 (2022-11-03) * abstract * * figure 8 * * paragraphs [0001], [0073] * | 1-15 | H05G |

The present search report has been drawn up for all claims

| Place of search | Date of completion of the search | Examiner |
|---|---|---|
| Munich | 30 November 2023 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 18 3484

This annex lists the patent family members relating to the patent documents cited in the above-mentioned European search report.
The members are as contained in the European Patent Office EDP file on
The European Patent Office is in no way liable for these particulars which are merely given for the purpose of information.

30-11-2023

| Patent document cited in search report | | | Publication date | Patent family member(s) | | | Publication date |
|---|---|---|---|---|---|---|---|
| US 2019155171 | A1 | | 23-05-2019 | CN | 109313390 | A | 05-02-2019 |
| | | | | IL | 262210 | A | 29-11-2018 |
| | | | | JP | 6895985 | B2 | 30-06-2021 |
| | | | | JP | 2019521368 | A | 25-07-2019 |
| | | | | KR | 20180135042 | A | 19-12-2018 |
| | | | | TW | 201740077 | A | 16-11-2017 |
| | | | | US | 2017315456 | A1 | 02-11-2017 |
| | | | | US | 2019155171 | A1 | 23-05-2019 |
| | | | | WO | 2017186491 | A1 | 02-11-2017 |
| US 2018220518 | A1 | | 02-08-2018 | CN | 107924118 | A | 17-04-2018 |
| | | | | IL | 256816 | A | 29-03-2018 |
| | | | | KR | 20180030191 | A | 21-03-2018 |
| | | | | TW | 201715198 | A | 01-05-2017 |
| | | | | US | 2018220518 | A1 | 02-08-2018 |
| | | | | US | 2019246480 | A1 | 08-08-2019 |
| | | | | WO | 2017025392 | A1 | 16-02-2017 |
| US 2023136618 | A1 | | 04-05-2023 | CN | 115699480 | A | 03-02-2023 |
| | | | | EP | 4165739 | A1 | 19-04-2023 |
| | | | | JP | 2023530924 | A | 20-07-2023 |
| | | | | KR | 20230023730 | A | 17-02-2023 |
| | | | | US | 2023136618 | A1 | 04-05-2023 |
| | | | | WO | 2021251966 | A1 | 16-12-2021 |
| CN 105333953 | A | | 17-02-2016 | NONE | | | |
| WO 2022228820 | A1 | | 03-11-2022 | IL | 307270 | A | 01-11-2023 |
| | | | | TW | 202309632 | A | 01-03-2023 |
| | | | | WO | 2022228820 | A1 | 03-11-2022 |

EPO FORM P0459

For more details about this annex : see Official Journal of the European Patent Office, No. 12/82

# EP 4 488 754 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1
- WO 2022228820 A1

### Non-patent literature cited in the description

- **LEMAILLET et al.** Intercomparison between optical and X-ray scatterometry measurements of FinFET structures. *Proc. of SPIE*, 2013, 8681